(19) **Europäisches Patentamt / European Patent Office / Office européen des brevets**

(11) **EP 1 742 357 A1**

(12) # EUROPEAN PATENT APPLICATION

(43) Date of publication:
**10.01.2007 Bulletin 2007/02**

(51) Int Cl.:
*H03H 17/06* (2006.01)

(21) Application number: **05106275.0**

(22) Date of filing: **08.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **DEUTSCHE THOMSON-BRANDT GMBH**
**78048 Villingen-Schwenningen (DE)**

(72) Inventors:
- **LO MUZIO, Pierluigi**
  **D-85622 Feldkirchen (DE)**
- **SCHEMMANN, Heinrich**
  **78048, Villingen-Schwenningen (DE)**

(74) Representative: **Thies, Stephan et al**
**Deutsche Thomson-Brandt GmbH,**
**European Patent Operations,**
**Karl-Wiechert-Allee 74**
**30625 Hannover (DE)**

(54) **Sample rate converter for a sigma delta DAC with an AES-EBU interface**

(57)     The invention relates to a sample rate converter for transforming a single input signal into two output signals, and whereby the output signals have different sampling rates, namely for sigma delta DAC and AES/EBU.

According to the invention, the sample rate converter includes:

- a first sample rate converter (1) having an output port (5),
- a digital-to-analog converter (6) connected to said output port (5) for outputting a first output signal,
- decimation unit (9) connected to said output port (5), and
- a formatter (11), to which an output port (10) of the decimation unit (9) is connected, for outputting a second output signal.

**Fig. 1**

EP 1 742 357 A1

**Description**

The present invention is related to the field of electronic devices, and more particularly without limitation, to circuitry and methods for the conversion of a digitally sampled input signal into two distinct output signals, whereby the output signals have sample rates which are different from each other.

US 5,666,299 discloses an asynchronous sample rate converter (ASRC) for the conversion of a digitally sampled input signal into a single output signal. The number of filter coefficients stored in a ROM are reduced by the design of the ASRC.

US 5,638,010 describes the generation of an asynchronous oversampled data stream for a $\Sigma\Delta$ DAC (sigma delta digital-to-analog converter) by using an ASRC and a digitally controlled oscillator (DCO). The ASRCs are synchronized by the DCO in a digital phase-locked loop (DPLL).

Computer simulations have shown that the ASRC according to US 5,638,010 yields a frequency spectrum having in-band components of roughly -115 dB, even if the correction circuit shown in figure 6 of US 5,638,010 is used. This makes the ASRC hardly acceptable when 20-bit audio quality is desired. Even more critical is the case when the master clock frequency equals a multiple of the audio input sample frequency, and when the master clock frequency deviates from the nominal frequency. The reason is that a large amount of alias folds back to the audio band. In this case the frequency spectrum of the ASRC disclosed in US 5,638,010 is unsatisfactory: the worst components are only at -85 dB.

US 6,215,423 B1 refers to asynchronous sample rate conversion. A circuit employed for this purpose accepts different sampling rates at its input, and outputs a digital signal as well as an analog signal. It uses a numerically controlled oscillator (NCO/DCO) which is controlled by a $\Sigma\Delta$ modulator. The NCO generates a clock synchronous to the system clock but having a time average frequency that is equal to a multiple of the asynchronous sample rate frequency required by the conversion. The generated clock is used to time an interpolator. US 6,215,423 B1 aims to avoid an analog PLL, and tries to achieve a simpler circuitry by avoiding a DSP or multipliers.

It is an object of the invention to provide a high-performance sample rate converter for oversampling a DAC which has an AES/EBU interface.

According to the present invention the above-mentioned object is achieved by providing the features defined in the independent claims. Preferred embodiments according to the invention additionally have the features defined in the sub-claims.

The above-mentioned object is achieved by using a sample rate converter which includes an asynchronous sample rate converter (ASRC). This ASRC includes a conventional n-tap polyphase interpolator and a computational entity for calculating the filter coefficients. Preferably, the computational entity is adapted to use a Parzen window or to use a quadratic window for calculating the filter coefficients.

As will be apparent from the below detailed description, this ASRC provides an output signal having a particularly good signal quality. One aspect of this signal quality is the fact that the attenuation of in-band noise components in the frequency spectrum is particularly high.

The attenuation of in-band components in the frequency spectrum is particularly high: in the case of a quadratic window these components are below -140 dB, in the case of a Parzen window their attenuation is even higher. As a consequence, the interpolation quality is increased.

In addition to the above ASRC a polyphase interpolation stage is preferably used, which interpolates an input signal by an integer factor, for example by a factor of 64. The output of the interpolation stage is fed into an ASRC, which itself outputs a signal for the DAC. In this case, any spurious components in the frequency spectrum of the DAC input are below -140 dB. This is true both for the quadratic window and for the Parzen window.

The sample rate converter according to the invention avoids the use of a complex and expensive analog PLL to generate multiple clock frequencies. Instead, a circuitry based on a unique programmable master clock and dividers is used. The desired oversampling frequency $F_{DAC}$ of the DAC is a multiple M of the master clock frequency $F_M$: $F_M = M * F_{DAC}$. M is a programmable integer value. Depending on the circumstances an additional DCO for the generation of the AES/EBU clock is added.

The invention is advantageously used in audio systems such as CD or DVD applications and set-top-box MPEG decoders. The present invention is particularly advantageous for an oversampling or sigma-delta DAC which has an AES/EBU interface. More generally, the invention is advantageously used in an apparatus for reading from and/or writing to recording media and/or for receiving a data stream.

These and other aspects of the invention will be apparent from and elucidated with reference to the embodiments and the corresponding claims described thereafter. It should be emphasized that the use of reference signs in the claims shall not be construed as limiting the scope of the invention.

Brief description of the drawings

Fig. 1    shows a first embodiment of the sample rate converter according to the invention,

Fig. 2    shows a further embodiment of the sample rate converter according to the invention, and

Fig. 3    shows the ASRC shown in Fig. 1 and Fig. 2 in more detail.

Detailed description of the drawings and description of the preferred embodiments

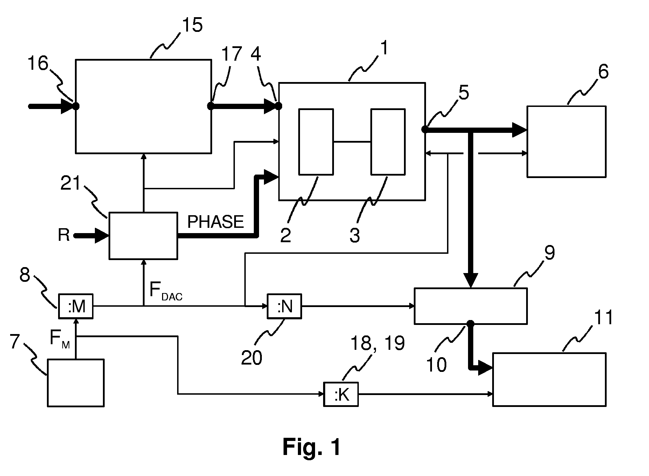

Fig. 1 schematically shows a first embodiment of the sample rate converter. The numerical values which are given below are applicable when the circuitry is used for a set-top-box MPEG decoder. It comprises a first ASRC 1 having an output port 5 connected to a $\Sigma\Delta$ DAC 6. Fig. 1 schematically shows that the ASRC 1 includes a 4-tap polyphase filter 2. The ASRC 1 further has a computational entity 3 for calculating the filter coefficients for the n-tap polyphase filter 2. In the embodiment of Fig. 1 the computational entity 3 is located within the ASRC 1. This, however, is not mandatory: in the alternative the computational entity is located outside the ASRC 1, and even outside the converter. In this case the computational entity might be a microprocessor or a DSP, or might be chosen to be a computer program running on an external device.

The computational entity 3 serves for calculating the filter coefficients, and is preferably adapted to use a Parzen window or a quadratic window for calculating the filter coefficients.

Apart from the $\Sigma\Delta$ DAC 6, the output port 5 of the first ASRC 1 is also connected to a master clock 7 via a unit 8 for dividing the master clock signal by an integer factor M, M1, and to a decimation unit 9. The output of the unit 8 provides a clock signal to drive the $\Sigma\Delta$ DAC 6. The decimation unit 9 has an output port 10 that is connected to an AES/EBU-formatter 11.

In Fig. 1, input samples are inputted at an input port 16 of an interpolation stage 15. The interpolation stage 15 is designed to interpolate by an integer factor, for example to interpolate the data received at port 16 by a factor of 64. The interpolated data samples are outputted at a port 17, and are fed into the ASRC 1 at an input port 4. The oversampling factor of the ASRC 1 is in the range of 1-2. Thus the sampling rate of data samples at the port 5 is higher than the sampling rate at the port 16 by a factor of 128.

As can be seen, the computational burden for interpolating the data samples is split between the interpolation stage 15 and the ASRC 1. This split has the advantage that the complexity of the ASRC 1 is decreased because the number of taps in the ASRC 1 is reduced. The necessity of this split depends on the oversampling factor and the signal-to-noise ratio (SNR) acceptable by the user.

The master clock 7 of the converter provides a master clock signal with a frequency $F_M$. A high flexibility in the choice of this master clock frequency limits any degradation of the high performance output signal of the ASRC 1. A convenient choice of the frequency range for $F_M$ is 100-500 MHz.

This unique clock 7 allows an easier integration of the converter in a SOC (system on a chip) environment.

All enable signals, which determine the operational speed and the system synchronization, are driven by the unique master clock 7. They are generated by dividing the master clock signal using simple counters or DCOs accordingly. These enable signals will be called clock signals within this description. Their phases (which do not represent the effective phases of the samples) are synchronized with the master clock 7, but their frequencies are asynchronous.

The $\Sigma\Delta$ DAC 6 is operated at a frequency $F_{DAC}$ which is synchronous with the master clock frequency: $F_{DAC}=M*F_M$. M is an integer number. $F_{DAC}$ may be 5.6448 MHz for CD applications or 6.144 MHz for set-top box (STB) applications. A jitter-free $F_{DAC}$ is provided by the dividing unit 8. If $F_S$ is the sampling rate of the input signal inputted at the port 16, the oversampling factor of the converter is the ratio $F_{DAC}/F_S$. In the above example of a CD application $F_S$=44.1 kHz; in the case of a STB application F=48 kHz. In both cases the oversampling factor of block 15 is 64. Because the ASRC 1 is an asynchronous converter, the total converter according to the invention is an asynchronous converter as well, and the above-mentioned ratio is not limited to integer values or rational numbers. As the input samples are not synchronized with the master clock 7, the oversampling factor fluctuates continuously around its nominal value.

Typical values of $F_S$ are 48 kHz, 44.1 kHz, or 32 kHz, but the converter is not limited to these sample frequencies. In a typical case $F_{DAC}$=6.144 MHz, such that the DAC oversampling factors are 128, 189.32, and 192 respectively.

The AES/EBU-formatter 11 is operated at a frequency of 48 kHz. With the values of $F_s$ as in the last paragraph the corresponding AES/EBU oversampling factors are 1, 48/44.1=1.088435, and 1.5.

Fig. 1 assumes that $F_{DAC}$/48 kHz is an integer value. In this case the samples are required at time instants when the ASRC 1 has already computed the output. For the input signal of the AES/EBU-formatter 11 it is thus sufficient to decimate the output at the port 5 by means of the decimation unit 9. No decimation filter is required because the ASRC 1 rejects all the spurious harmonics in the spectrum. Units 20 and 18 are frequency dividing units with divisors N and K, respectively, whereby N and K are integers with $N=F_{DAC}/48$ kHz and $K=F_M/6.144$ MHz. The value R of the register of a DCO 21, which determines the oversampling ratio, is $R=round(64*Fs*2^{nacc}*M/F_M)$, where nacc is the number of bits of the accumulator in the DCO 21; nacc determines the frequency precision of the DCO 21.

The decimation unit 9 decimates the data samples outputted at the port 5 by a factor of 128. The clock signal is provided by the frequency dividing unit 20. This unit 20 receives the output of unit 8 and frequency divides the clock signal accordingly.

The circuitry shown in Fig. 1 assumes that K is an integer. In that case a clock signal for the AES/EBU formatter 11 is provided by dividing the master clock frequency with the help of the frequency dividing unit 18. If, however, this condition is not satisfied, i.e. K is not an integer, the unit 18 is replaced by a synthesizer 19, for example a DCO, for synthesizing a frequency of 6.144 MHz. This represents a second embodiment of the invention. For the synchronization of the synthesizer 19 with the samples of 48 kHz, the synthesizer 19 has to be reset by the clock at 48 kHz.

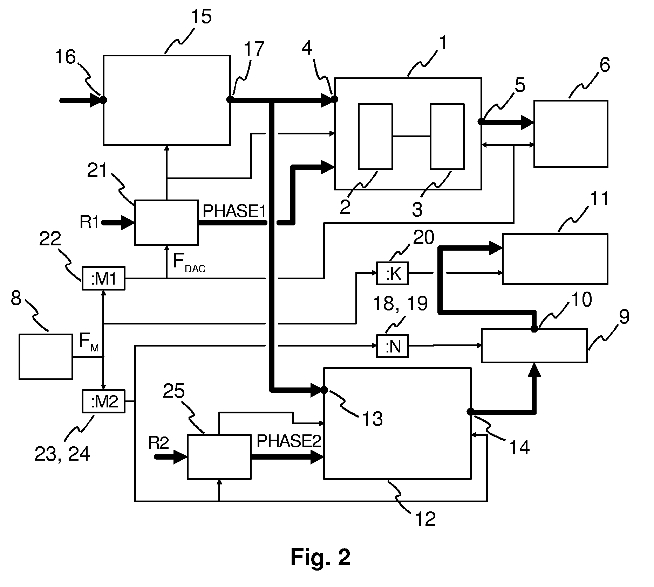

While the first embodiment assumes that N and K are integers, in the second embodiment K is not an integer. In a third embodiment K is an integer, but N is not. In that case new samples for the $\Sigma\Delta$ DAC 6 and for the AES/EBU formatter 11 are requested at different time instants. This is accomplished by the embodiment shown in Fig. 2. The input for the $\Sigma\Delta$ DAC 6 remains unchanged. The frequency dividing unit 8 of Fig. 1 is replaced by a corresponding unit 22 dividing the frequency of the master clock 7 by a factor of M1.

This unit 22 can be supplemented by an optional frequency dividing unit 23 dividing the frequency of the master clock 7 by a factor of M2. The unit 23 increases the precision of the frequency which is generated by a DCO 25. The clock at the input of the DCO 25 should be higher than the sampling rate of the signal at the port 15.

The circuitry of Fig. 2 shows a second ASRC 12 being preferably identical to the first ASRC 1. The ASRC 12 receives at its input 13 the same input signal from the port 17 as the first ASRC 1. This reduces the complexity of the circuitry. Furthermore, the availability of data samples already interpolated by a factor of 64 by the interpolation stage 15 reduces the computational burden of the second ASRC 12.

The second ASRC 12 receives a second clock from the DCO 25, which is different from the first clock of the ASRC 1. However, these two clocks can be synchronized. In practice the phases of the two clocks are different from each other, but the phase variation must not jump around the clock edge of the first clock. Furthermore, the frequencies must be exactly the same. These requirements are met if the following conditions are respected.

a) Equal frequency: The rounding R1 and R2 of the DCO 21 and the DCO 25 are selected such that R1/R2=M1/M2.

b) Phase: At the reset the DCO 21 should start in advance with an offset, and $R1/R2\geq R2/M2$, so that the clock edges at the output of the DCO 25 are always later than the clock edges at the output of the DCO 21.

As an example, conditions a) and b) are met if an integer submultiple of R1 and R2 is defined to be $R3=round(64*Fs*2^{nacc1}/F_M)$, and R1 and R2 are chosen to be $R1=M1*R3$ and $R2=M2*R3*2^{nacc2-nacc1}$, respectively. In this case, nacc2>nacc1 has been assumed.

In a further embodiment neither K nor N is an integer. In this case the unit 23 is replaced by a DCO 24.

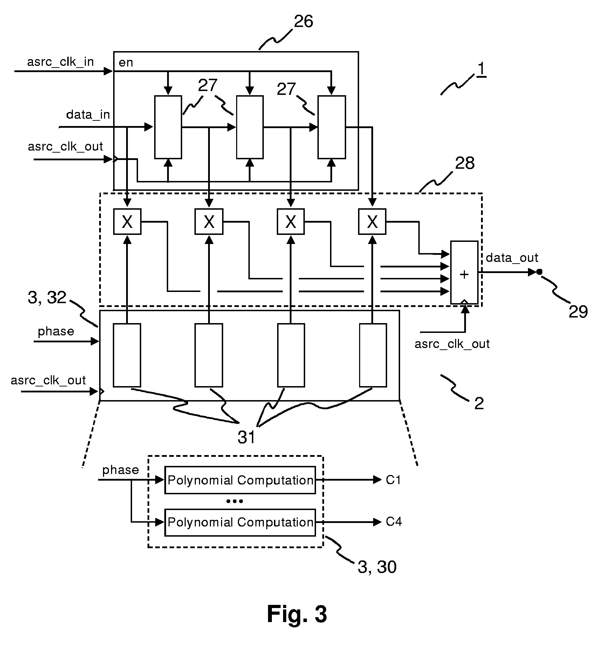

Fig. 3 schematically shows the ASRC 1 according to the invention. It includes a 4-tap polyphase filter 2 which has a delay pipeline 26 and a digital signal processor (DSP) 28. The clock signal ascr_clk_in enables the delay pipeline 26 and clocks input data data_in sequentially through data registers (or flip-flops) 27, such that the utmost left register contains the newest sample, and the utmost right register the oldest sample.

The clock signal asrc_clk_in is in general a jittered clock because it is phase-synchronous with asrc_clk_out and frequency synchronous with data_in. Typically, this clock is generated by means of the DCO of a digital PLL. This DCO uses the same clock signal asrc_clk_out, which synchronizes all registers 27.

The ASRC 1 can be conveniently used when the input data data_in are represented by an oversampled signal. For the purposes of this disclosure an oversampled signal shall be understood to be a signal having a sample rate significantly higher than the minimum sampling rate $F_{MIN}$. Taking the Nyquist theorem into account the minimum sampling rate $F_{MIN}$ is twice the bandwidth.

Filtering is performed by averaging the sample points from data registers 27. The sample points are multiplied by the DSP 28 with their corresponding weighing/filter coefficients. The sum of all weighted sample points is outputted by the DSP 28 at an output port 29.

In Fig. 3 the n-tap filter 2 (n is an integer) has four taps. The invention however is not restricted to a case of four taps. n may be chosen to be 2, 3, 4,....

There are two ways of generating the filter coefficients.

The first possibility is the generation of the filter coefficients by a computational entity 3, whereby the computational entity 3 is located external to the converter. This computational entity 3 might be hardware such as a DSP or an ASIC, or may be a computer program running on a remote computer.

The second possibility is the generation of the filter coefficients by a computational entity 3, whereby the computational entity 3 is located inside the converter. In other words the computational entity 3 is part of the converter. In this case the computational entity 3 is the coefficient generator 30 of Fig. 3. Advantageously, the coefficient generator 30 has a limited complexity when the input signals are oversampled signals.

When the first possibility is chosen the n-tap polyphase filter 2 has to provide memory space for the filter coefficients which are generated externally (outside the n-tap polyphase filter 2). In this case the phase signal is used as the reading address of four independent memory units 31, whereby each memory unit 31 of block 32 holds all the $2^P$ possible values of a specific coefficient, with P being the number of bits of the phase signal. For a precise interpolation, for instance with P=9, the required memory in block 32 is $2^9*4$ words. As can be derived from the above explanations, block 32 is a pure memory block in this (first) operation mode. Block 30 can be regarded as the external computational entity.

When the second possibility is chosen, the phase signal is used for the polynomial computation of the filter coefficients by means of a computational entity 32. Typically the phase signal is generated by the DCO of a digital PLL. The four coefficients are $C_m = A_m*I + B_m*I2 + C_m*I3 + D_m*I3'$ where m is an index ranging from 1 to 4, and where I is the input phase signal. The coefficients are either calculated on the fly (online calculation), or are have been preloaded (offline calculation).

When the second possibility for generating the filter coefficients is chosen the calculation of the filter coefficients is performed in block 32. In this (second) operation mode block 32 is a coefficient generator or computational entity. Details of block 32 serving as a computational entity are visualized by means of block 30. It should be emphasized, however, that block 30 is merely a representation of block 32, and is not a separate physical entity. Block 30 thus zooms into block 32. The constants $A_m$, $B_m$, $C_m$, $D_m$ etc. are retrieved from a small memory unit (not shown). In this example a third order polynomial is chosen, such that a total of 16 coefficients are stored, whereby each coefficient needs a memory space of only four words. This solution for the coefficient generator reduces the required memory at the expenses of additional polynomial computations and it is generally better when a very precise interpolation is needed.

The invention uses the Parzen window or the quadratic window as the polynomial smart window. The Parzen window, also referred to as the de la Valle Poussin window, is a third order polynomial and is defined as

$$w(n) = 1 - 6 \cdot \left(\frac{n}{N/2}\right)^2 \cdot \left(1 - \frac{|n|}{N/2}\right) \quad 0 \leq |n| \leq N/4$$

$$w(n) = 2 \cdot \left(1 - \frac{|n|}{N/2}\right)^3 \quad\quad N/4 < |n| \leq N/2$$

whereby $n$ is the index of the time samples, and $N+1$ is the total length of the window. In the alternative, a quadratic window is chosen. This is a second order polynomial which is defined as

$$w(n) = 1 - 2 \cdot \left(\frac{n}{N/2}\right)^2 \quad 0 \leq |n| \leq N/4$$

$$w(n) = 2 \cdot \left(1 - \frac{|n|}{N/2}\right)^2 \quad N/4 < |n| \leq N/2$$

**List of reference numerals**

1       first asynchronous sample rate converter (ASRC)
2       n-tap polyphase filter
3       computational entity
4       input port of the first ASRC
5       output port of the first ASRC
6       sigma delta digital-to-analog converter ($\Sigma\Delta$ DAC)
7       master clock
8       frequency dividing unit
9       decimation unit
10      output port of the decimation unit
11      AES/EBU-formatter
12      second asynchronous sample rate converter (ASRC)
13      input port of the second ASRC
14      output port of the second ASRC
15      interpolation stage
16      input port of the interpolation stage
17      output port of the interpolation stage
18      frequency dividing unit
19      synthesizer
20      frequency dividing unit
21      DCO
22      frequency dividing unit
23      frequency dividing unit
24      DCO
25      DCO
26      delay pipeline
27      register
28      digital signal processor (DSP)
29      output port
30      coefficient generator
31      memory unit
32      memory block, computational entity

SOC     system on a chip
$F_M$      master clock frequency
$F_{DAC}$    operational frequency of DAC 6

**Claims**

1.   Sample rate converter for transforming an input signal into two output signals, **including:**

- a first sample rate converter (1) having an output port (5),
- a digital-to-analog converter (6) connected to said output port (5) for outputting a first output signal,
- a decimation unit (9) connected to said output port (5), and
- a formatter (11), to which an output port (10) of the decimation unit (9) is connected, for outputting a second output signal.

2.   Sample rate converter according to claim 1, **further** including a second sample rate converter (12), wherein instead of said output port (5) of said first sample rate converter (1) an output port (14) of said second sample rate converter (12) is connected to the decimation unit (9).

3.   Sample rate converter according to claim 2, wherein said first sample rate converter (1) and said second sample rate converter (12) are identical.

4.   Sample rate converter according to one of claims 1 to 3, **wherein** at least of said first sample rate converter (1) and said second sample rate converter (12) is an asynchronous sample rate converter having an n-tap polyphase interpolator (2) and a computational entity (3) for calculating filter coefficients.

5. Sample rate converter according to one of claims 1 to 4, **further** including:

   - a master clock (7), and
   - at least one unit (8, 18) for dividing the master clock signal by an integer factor (M, M1, K) for providing a clock signal to drive said digital-to-analog converter (6) and/or said formatter (11).

6. Sample rate converter according to one of claims 1 to 5, **further** including an interpolation stage (15) having an output (17) to which at least one of said first sample rate converter (1) and said second sample rate converter (12) is connected.

7. Sample rate converter according to one of claims 1 to 6, **wherein** said formatter (11) is an AES/EBU-formatter.

8. Sample rate converter according to one of claims 1 to 7, **wherein** said digital-to-analog converter (6) is a $\Sigma\Delta$ DAC.

9. Sample rate converter according to one of claims 1 to 8, **wherein** the clock frequency ($F_M$) of the master clock (7) is an integer multiple (M) of the clock frequency ($F_{DAC}$) of the digital-to-analog converter.

10. Sample rate converter according to claim 5, **wherein** at least one of the units (8, 18) for dividing the master clock signal by an integer factor (M, M1, K) is replaced by a digitally controlled oscillator (19, 24).

11. Apparatus for reading from and/or writing to recording media and/or for receiving a data stream, **characterized in that** it includes a sample rate converter according to one of claims 1 to 10.

**Fig. 1**

**Fig. 2**

**Fig. 3**

**European Patent Office**

# EUROPEAN SEARCH REPORT

Application Number

EP 05 10 6275

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/187529 A1 (LEE STEVEN K) 2 October 2003 (2003-10-02) * paragraph [0028] - paragraph [0039]; figure 4 * ----- | 1-11 | H03H17/06 |
| X | US 2001/010040 A1 (HINDERKS LARRY W) 26 July 2001 (2001-07-26) * paragraph [0248] - paragraph [0258]; figure 2 * ----- | 1-11 | |
| X | KIRBY D G ET AL: "DIGITAL AUDIO EDITING: THE DEVELOPMENT OF A RANDOM ACCESS EDITOR" BBC RESEARCH AND DEVELOPMENT REPORT, BRITISH BROADCASTING CORPORATION, GB, no. 5, January 1990 (1990-01), pages 1-9,A, XP000165081 ISSN: 1361-2379 * paragraph [0003]; figure 3 * ----- | 1-11 | |
| A | US 6 215 423 B1 (MAY MARCUS W ET AL) 10 April 2001 (2001-04-10) * the whole document * ----- | 1-11 | TECHNICAL FIELDS SEARCHED (IPC) H03H |

The present search report has been drawn up for all claims

| Place of search | Date of completion of the search | Examiner |
|---|---|---|
| The Hague | 20 January 2006 | Lecoutre, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 10 6275

This annex lists the patent family members relating to the patent documents cited in  the above-mentioned European search report.
The members are as contained in the European Patent Office EDP file on
The European Patent Office is in no way  liable for these particulars which are merely  given for the purpose of information.

20-01-2006

| Patent document cited in search report | | Publication date | Patent family member(s) | | Publication date |
|---|---|---|---|---|---|
| US 2003187529 | A1 | 02-10-2003 | AU | 2003223377 A1 | 20-10-2003 |
| | | | WO | 03085547 A1 | 16-10-2003 |
| US 2001010040 | A1 | 26-07-2001 | NONE | | |
| US 6215423 | B1 | 10-04-2001 | NONE | | |

EPO FORM P0459

For more details about this annex : see Official Journal of the European Patent Office, No. 12/82

**EP 1 742 357 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5666299 A
- US 5638010 A
- US 6215423 B1